# EUROPEAN PATENT APPLICATION

(11) **EP 2 840 615 A1**
(43) Date of publication of application: **25.02.2015**
(21) Application number: 14180709.9
(22) Date of filing: 12.08.2014
(51) Int. Cl.: H01L 31/05, H02S 20/10, H02S 40/36, H01L 31/042

(54) **Photoelectric module**

(30) Priority: 19.08.2013 KR 20130098139
(71) Applicant: Samsung SDI Co., Ltd., Yongin-si, Gyeonggi-do (KR)
(72) Inventor: Kim, Bum-Rae, Gyeonggi-do (KR); Lee, Seung-Hee, Gyeonggi-do (KR); Jung, Chan-Yoon, Gyeonggi-do (KR); Moon, Jun-Ho, Gyeonggi-do (KR); Lee, Dong-Jun, Gyeonggi-do (KR); Kim, Myung-Hwan, Gyeonggi-do (KR); Jeon, Hoon-Ha, Gyeonggi-do (KR); Chong, Joong-Gun, Gyeonggi-do (KR)
(74) Representative: Taor, Simon Edward William

(57) **Abstract**

A photoelectric module includes first and second photoelectric devices, and a connection support member electrically and structurally connecting the first and second photoelectric devices, the connection support member including a conductive core including an accommodation slot portion configured to accommodate portions of the first and second photoelectric devices, the accommodation slot portions electrically contacting bus lines extending out of the first and second photoelectric devices, and an insulation molding configured to insulate the conductive core.

## Description

One or more embodiments relate to a photoelectric module, and more particularly, to a photoelectric module including at least two photoelectric devices.

The development of clean energy has been recently accelerated to cope with energy exhaustion and environmental pollution. Solar energy generation for generating electricity from sunlight using solar cells is considered as a representative example of using clean energy.

For example, photoelectric modules are used to generate electricity from sunlight, and such a photoelectric module includes many photoelectric devices connected in series or parallel to satisfy a required level of output power. For example, a plurality of photoelectric devices may be electrically connected using junction boxes.

According to one or more embodiments, a photoelectric module includes first and second photoelectric devices, and a connection support member electrically and structurally connecting the first and second photoelectric devices, the connection support member including a conductive core including an accommodation slot portion configured to accommodate portions of the first and second photoelectric devices, the accommodation slot portions electrically contacting bus lines extending out of the first and second photoelectric devices, and an insulation molding configured to insulate the conductive core.

The accommodation slot portion may accommodate portions of the first and second photoelectric devices from which the bus lines may extend outward.

The conductive core may include a pair of accommodation slot portions to accommodate the first and second photoelectric devices, respectively.

The conductive core may further include a connection portion electrically connecting the pair of accommodation slot portions.

The pair of accommodation slot portions may be opened in opposite directions.

The pair of accommodation slot portions may accommodate mutually-facing sides of the first and second photoelectric devices, respectively.

Each of the pair of accommodation slot portions may have a bent shape and include: an upper plate; a lower plate; and a lateral plate connecting the upper and lower plates.

The insulation molding may include: an upper plate cover portion covering the upper plates of the pair of accommodation slot portions; a lower plate cover portion covering the lower plates of the pair of accommodation slot portions; and a block portion formed between the upper plate cover portion and the lower plate cover portion to surround a connection portion between the pair of accommodation slot portions.

The pair of accommodation slot portions may be opened in the same direction.

The pair of accommodation slot portions may accommodate neighboring corner portions of the first and second photoelectric devices, respectively.

The insulation molding may: a first portion extending in a first direction parallel with the conductive core to insulate the conductive core; and a second portion extending from the first portion in a second direction parallel with the first and second photoelectric devices for insulating the first and second photoelectric devices from each other.

The first and second portions of the insulation molding may be formed in one piece, and the insulation molding may have a T-shape.

The accommodation slot portion may have a bent shape and include: an upper plate; a lower plate; and a lateral plate connecting the upper and lower plates, wherein the bus lines may make contact with the lateral plate of the accommodation slot portion.

Each of the first and second photoelectric devices may include first and second substrates coupled to face each other, and each of the bus line may extend outward from a region between the first and second substrates.

Each of the bus lines extending outward from a region between the first and second substrates may be bent around an edge portion of the first substrate to extend on a top side of the first substrate, or may be bent around an edge portion of the second substrate to extend on a bottom side of the second substrate.

The insulation molding may be formed on an outer surface of the accommodation slot portion, and an insulation coating may be formed on an outer surface of the insulation molding to protect the insulation molding.

An insulation filler may be filled in the accommodation slot portion.

The insulation filler may seal contacts between the accommodation slot portion and the bus lines.

The photoelectric module may further include an installation frame configured to support the first and second photoelectric devices above a bottom surface, wherein the first and second photoelectric devices may be coupled to the installation frame through the connection support member.

The connection support member may be coupled to the installation frame.

According to one or more embodiments, a photoelectric module includes first and second photoelectric devices, at least one bus line extending outward from each of the first and second photoelectric devices, and a connection support member electrically and structurally connecting the first and second photoelectric devices, each of the bus lines extending outward from the first and second photoelectric devices contacting at least two sides of the connection support member.

The connection support member may include a conductive core, and the conductive core may include an accommodation slot portion configured to accommodate portions of the first and second photoelectric devices for making contact with the bus lines extending outward from the first and second photoelectric devices.

The connection support member may further include an insulation molding to insulate the conductive core.

The accommodation slot portion may have a bent shape and include: an upper plate; a lower plate; and a lateral plate connecting the upper and lower plates.

Each of the bus lines extending outward from the first and second photoelectric devices may make electric contact with the lateral and upper plates, or the lateral and lower plates of the accommodation slot portion.

The conductive core may include a pair of accommodation slot portions to accommodate the first and second photoelectric devices, respectively.

The pair of accommodation slot portions may be opened in opposite directions.

The pair of accommodation slot portions may accommodate mutually-facing sides of the first and second photoelectric devices, respectively.

The pair of accommodation slot portions may be opened in the same direction.

The pair of accommodation slot portions may accommodate neighboring corner portions of the first and second photoelectric devices, respectively.

According to an aspect of the invention, there is provided a photoelectric module as set out in claim 1. Preferred features are set out in claims 2 to 15.

Features will become apparent to those of ordinary skill in the art by describing in detail exemplary embodiments with reference to the attached drawings, in which:
FIG. 1 illustrates an exploded perspective view of a photoelectric module according to an embodiment;
FIG. 2 illustrates a partial enlarged view of the photoelectric module in FIG. 1;
FIG. 3 illustrates a cross-sectional view of the photoelectric module in FIG. 2;
FIG. 4 illustrates a partial perspective view of a modification of the photoelectric module illustrated in FIG. 2;
FIG. 5 illustrates a view of a photoelectric module according to another embodiment;
FIGS. 6 and 7 illustrate enlarged perspective views of a connection support member illustrated in FIG. 5;
FIG. 8 illustrates a partial cross-sectional view of the photoelectric module in FIG. 5;
FIG. 9 illustrates a partial exploded view of a modification of the photoelectric module illustrated in FIG. 5;
Fig. 10 illustrates a plan view of the photoelectric device in FIG. 9;
FIG. 11 illustrates a view of another aspect of the photoelectric module in FIG. 1;
FIG. 12 illustrates a cross-sectional view of a modification of the photoelectric module in FIG. 3; and
FIG. 13 illustrates a cross-sectional view of a modification of the photoelectric module illustrated in FIG. 8.

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. In addition, it will also be understood that when a layer is referred to as being "between" two layers, it can be the only layer between the two layers, or one or more intervening layers may also be present. Like reference numerals refer to like elements throughout.

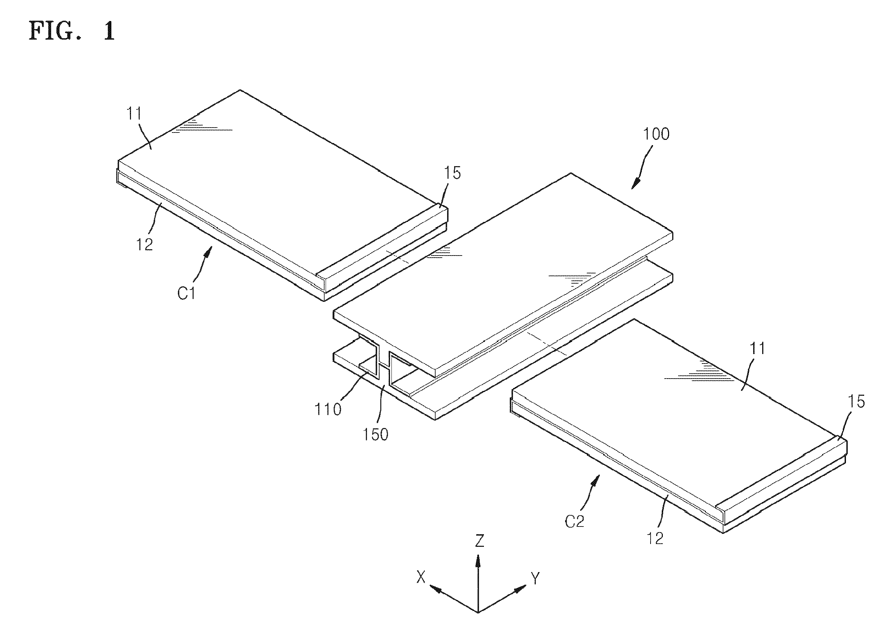

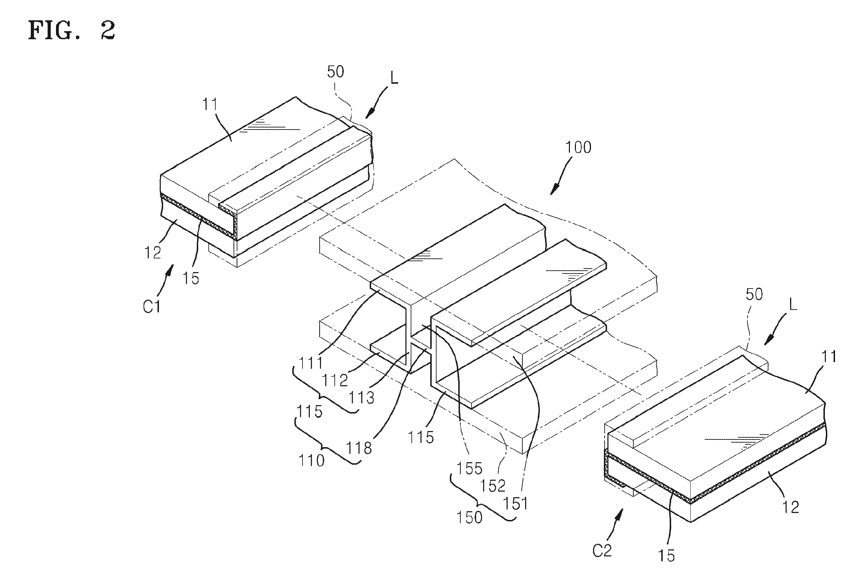

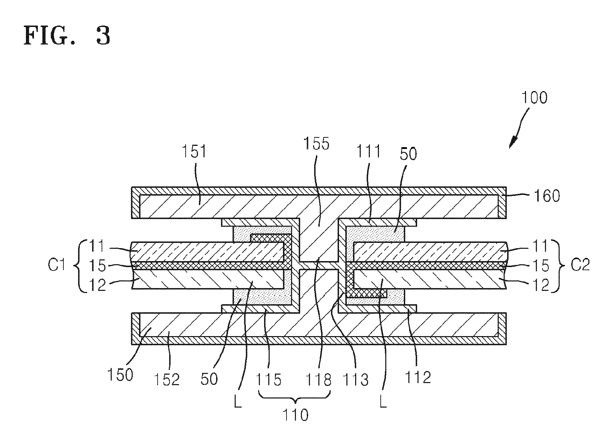

Hereinafter, a photoelectric module will be described according to an embodiment. FIG. 1 illustrates an exploded perspective view of a photoelectric module according to an embodiment, and FIG. 2 illustrates an enlarged view partially illustrating the photoelectric module in FIG. 1. FIG. 3 illustrates a cross-sectional view partially illustrating the photoelectric module in FIG. 2.

Referring to FIGS. 1 to 3, the photoelectric module may include at least two photoelectric devices C1 and C2, and a connection support member 100 configured to electrically and structurally connect the photoelectric devices C1 and C2.

Each of the photoelectric devices C1 and C2 may include at least one photoelectric cell (not shown). In the current embodiment, each of the photoelectric devices C1 and C2 may include a plurality of photoelectric cells electrically connected in series or parallel, or in series and parallel.

Each of the photoelectric devices C1 and C2 may include first and second substrates 11 and 12 facing each other, a light absorption layer (not shown) disposed between the first and second substrates 11 and 12, and a bus line 15 through which carriers generated in the light absorption layer are transmitted to an external device. For example, the bus line 15 may extend from a region between the first and second substrates 11 and 12. For example, a plurality of photoelectric cells (not shown) may be disposed between the first and second substrates 11 and 12, and neighboring photoelectric cells may be electrically connected to each other. In this case, a pair of bus lines 15 may extend outward from opposite ends of the plurality of photoelectric cells, and the pair of bus lines 15 may have opposite polarities.

The photoelectric devices C1 and C2 may have a rectangular shape having a pair of long sides and a pair of short sides. The bus lines 15 may extend outward from sides L of the photoelectric devices C1 and C2, and the sides L may be long or short sides of the photoelectric devices C1 and C2.

The bus lines 15 may include a flexible conductive material and have a ribbon or a conductive tape shape. For example, in each of the photoelectric devices C1 and C2, the bus line 15 may extend outward from a region between the first and second substrates 11 and 12 and may be flexibly bent (or bend) around an edge portion of the first substrate 11 or the second substrate 12. Then, the bus line 15 may extend on the top side of the first substrate 11 or the bottom side of the second substrate 12. The bus line 15 may be electrically connected to the connection support member 100 by making surface contact with the connection support member 100.

As described above, the photoelectric module of the current embodiment may include at least two photoelectric devices C1 and C2, and the photoelectric devices C1 and C2 may be electrically connected to each other through the connection support member 100. The connection support member 100 accommodates the bus lines 15 extending outward from the (first and second) photoelectric devices C1 and C2 and electrically connects the first and second photoelectric devices C1 and C2. For example, the connection support member 100 may accommodate the sides L of the first and second photoelectric devices C1 and C2 from which the bus lines 15 extend outward.

The connection support member 100 may accommodate the sides L of the first and second photoelectric devices C1 and C2. The (first) bus line 15 extending outward from the first photoelectric device C1 may be electrically connected to the (second) bus line 15 extending outward from the second photoelectric device C2 through the connection support member 100.

The connection support member 100 may include a conductive core 110 having accommodation slot portions 115 for receiving portions of the first and second photoelectric devices C1 and C2, and an insulation molding 150 for insulating the conductive core 110. For example, as illustrated in FIG. 1, the insulation molding 150 may be only on outer surfaces of the conductive core 110, so inner surfaces of the conductive core 110, e.g., surfaces defining the accommodation slot portions 115, may be exposed to accommodate and contact the first and second photoelectric devices C1 and C2.

For example, the accommodation slot portions 115 may be provided as a pair to accommodate the sides L of the first and second photoelectric devices C1 and C2. In this way, the first and second photoelectric devices C1 and C2 may be electrically and structurally connected by the connection support member 100 to form a module. For example, in the embodiment shown in FIG. 2, the pair of accommodation slot portions 115 may be formed on opposite sides of the connection support member 100 and open in opposite directions so as to accommodate the first and second photoelectric devices C1 and C2 in mutually facing directions.

The conductive core 110 electrically connects the first and second photoelectric devices C1 and C2. The conductive core 110 may make surface contact with the first and second bus lines 15 of the first and second photoelectric devices C1 and C2 inserted in the accommodation slot portions 115.

In detail, the conductive core 110 may include the accommodation slot portions 115 and a connection portion 118 connecting the accommodation slot portions 115. Each of the accommodation slot portions 115 may have a bent plate shape. Each of the accommodation slot portions 115 may include an upper plate 111, a lower plate 112, and a lateral plate 113 connecting the upper plate 111 and the lower plate 112. The connection portion 118 may have a flat plate shape that connects the accommodation slot portions 115, e.g., the connection portion 118 may extend between and connect the lateral plates 113 of the accommodation slot portions 115.

The conductive core 110 may have a sufficient length, e.g., along the y-axis, for covering the sides L of the first and second photoelectric devices C1 and C2 along which the first and second bus lines 15 extend outward. The conductive core 110 may be formed of any suitable conductive material, e.g., a hard metal plate or a soft metal foil by any suitable forming method.

The insulation molding 150 may insulate the conductive core 110. In detail, the insulation molding 150 may include an upper plate cover portion 151, e.g., continuously, covering the upper plates 111 of the pair of accommodation slot portions 115, a lower plate cover portion 152, e.g., continuously, covering the lower plates 112 of the pair of the accommodation slot portions 115, and a block portion 155 formed between the upper plate cover portion 151 and the lower plate cover portion 152 covering, e.g., opposite surfaces of, the connection portion 118 connected between the pair of accommodation slot portions 115.

The upper plate cover portion 151 and the lower plate cover portion 152 may have a plate shape to cover the upper plates 111 and the lower plates 112 of the accommodation slot portions 115. The block portion 155 may insulate the connection portion 118 connected between the accommodation slot portions 115.

The upper plate cover portion 151, the lower plate cover portion 152, and the block portion 155 of the insulation molding 150 may be formed in one piece. For example, the insulation molding 150 may be formed of an insulation resin in some embodiments of the invention.

The insulation molding 150 covers the conductive core 110 except for inner sides of the accommodation slot portions 115. Therefore, the first and second photoelectric devices C1 and C2 (the first and second bus lines 15) may be electrically connected to the conductive core 110 when being inserted into the accommodation slot portions 115.

For example, the conductive core 110 and the insulation molding 150 may be formed in one piece by an injection molding method. In other embodiments, the conductive core 110 may be bonded to inner sides of the insulation molding 150.

Assembling of the connection support member 100 and the first and second photoelectric devices C1 and C2 will now be described. The sides L of the first and second photoelectric devices C1 and C2 are pointed to the connection support member 100 and are inserted into the accommodation slot portions 115 of the connection support member 100. In detail, when the sides L of the first and second photoelectric devices C1 and C2, on which the first and second bus lines 15 extend, are inserted into the accommodation slot portions 115, the first and second bus lines 15 may be smoothly bent (or bend) according to the shapes of the inner sides of the accommodation slot portions 115 and may be brought into electric contact with the accommodation slot portions 115.

For example, referring to FIG. 3, in one of the accommodation slot portions 115, the first bus line 15 extending outward from a region between the first and second substrates 11 and 12 of the first photoelectric device C1 may be bent (or bend) around an edge portion of the first substrate 11 and may extend on the top side of the first substrate 11. Similarly, in the other of the accommodation slot portions 115, the second bus line 15 extending outward from a region between the first and second substrates 11 and 12 of the second photoelectric device C2 may be bent (or bend) around an edge portion of the second substrate 12 and may extend on the bottom side of the second substrate 12. For example, in each of the accommodation slot portions 115, the bus line 15 may make contact with at least one side of the accommodation slot portion 115. For example, in each of the accommodation slot portions 115, the bus line 15 may make electric contact with the lateral plate 113 of the accommodation slot portion 115.

The first and second bus lines 15 of the first and second photoelectric devices C1 and C2 make contact with the accommodation slot portions 115, respectively, and are electrically connected to each other through the connection portion 118. For example, the first and second bus lines 15 of the first and second photoelectric devices C1 and C2 may have different polarities, and may be connected in series through the connection support member 100.

Referring to FIG. 3, insulation coatings 160 may be formed on the connection support member 100. The insulation coatings 160 formed on the connection support member 100 may protect inner parts of the connection support member 100, e.g., the insulation molding 150, from harsh environments, e.g., temperature variations and moisture. For example, the insulation coatings 160 may be formed on the entire outer surface of the insulation molding 150 or portions of the outer surface of the insulation molding 150. The insulation coatings 160 may be formed of an insulation resin more resistant to moisture than a material used to form the insulation molding 150.

The accommodation slot portions 115, at which the first and second photoelectric devices C1 and C2 make contact with the connection support member 100, may be insulated from the external environment. In the current embodiment, an insulation filler 50 may be filled in the accommodation slot portions 115. The insulation filler 50 may protect and insulate contacts between the accommodation slot portions 115 and the first and second photoelectric devices C1 and C2 from the external environment.

For example, an insulation filler having, e.g., exhibiting, fluidity may be applied to the sides L of the first and second photoelectric devices C1 and C2, and the sides L of the first and second photoelectric devices C1 and C2 may be inserted into the accommodation slot portions 115 to seal the contacts between the first and second photoelectric devices C1 and C2 and the accommodation slot portions 115. Thereafter, the insulation filler 50 may be hardened.

In the current embodiment, the insulation filler 50 may be fully filled in the accommodation slot portions 115 or partially filled in the accommodation slot portions 115 to a degree sufficient to seal the contacts between the accommodation slot portions 115 and the first and second photoelectric devices C1 and C2. The insulation filler 50 may include an insulation resin having fluidity.

In the current embodiment, the photoelectric module includes two photoelectric devices C1 and C2. In other embodiments, the photoelectric module may include three or more photoelectric devices. For example, the photoelectric module may include first through third photoelectric devices (not shown). In this case, the photoelectric module may include a first connection support member electrically connecting the first and second photoelectric devices, and a second connection support member electrically connecting the second and third photoelectric devices. The electrically-connected first to third photoelectric devices may be arranged in a row with the first and second connection support members being disposed therebetween.

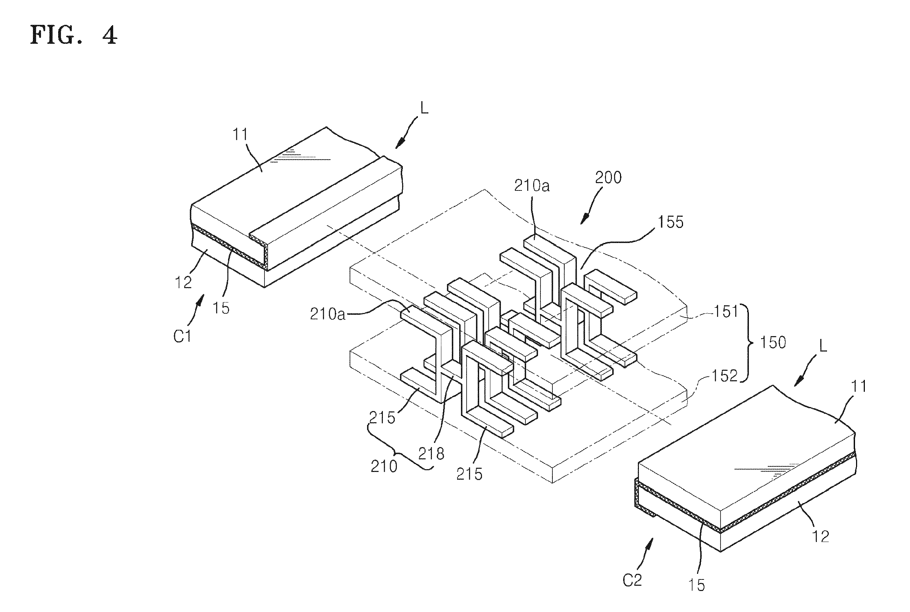

FIG. 4 illustrates a partial perspective view of a modification of the photoelectric module in FIG. 2. Referring to FIG. 4, the modified photoelectric module may include first and second photoelectric devices C1 and C2, and a connection support member 200 electrically and structurally connecting the first and second photoelectric devices C1 and C2. The connection support member 200 may include a conductive core 210 and the insulation molding 150 insulating the conductive core 210. The conductive core 210 may include a plurality of lines 210a. In other words, the conductive core 210 may include a plurality of separate lines 210a. The number and widths of the lines 210a and the intervals between the lines 210a may be determined according to a degree of electric resistance between the first and second photoelectric devices C1 and C2. In detail, the conductive core 210 may include accommodation slot portions 215 for receiving sides L of the first and second photoelectric devices C1 and C2, and a connection portion 218 electrically connecting the accommodation slot portions 215.

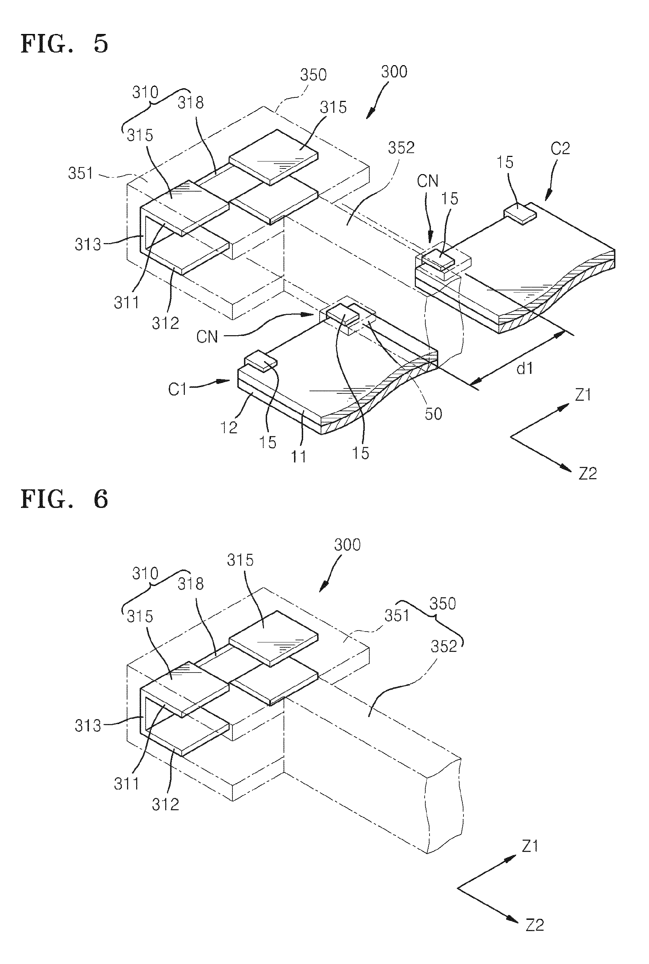

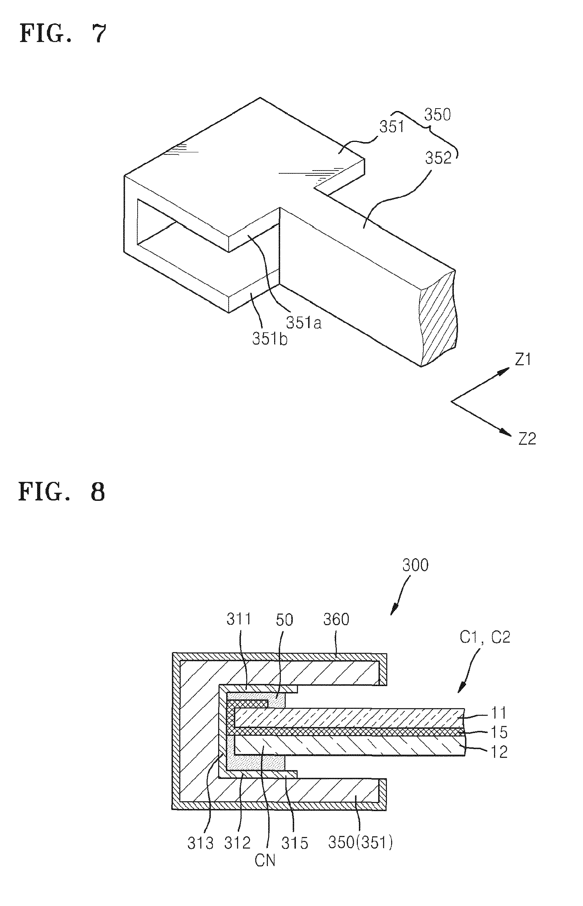

FIG. 5 illustrates a view of a photoelectric module according to another embodiment. FIGS. 6 and 7 illustrate enlarged perspective views of a connection support member in FIG. 5. FIG. 8 illustrates a cross-sectional view of the connection support member illustrated in FIGS. 6 and 7.

Referring to FIGS. 5 to 8, the photoelectric module may include at least two (first and second) photoelectric devices C1 and C2, and a connection support member 300 configured to electrically and structurally connect the photoelectric devices C1 and C2.

Each of the first and second photoelectric devices C1 and C2 may include the first and second substrates 11 and 12 coupled to face each other, and the bus line 15 extending outward from the region between the first and second substrates 11 and 12. The bus lines 15 of the first and second photoelectric devices C1 and C2 may be electrically connected to each other through the connection support member 300. By this, the first and second photoelectric devices C1 and C2 may be electrically connected in series or parallel. For example, the bus lines 15 may include a pair of bus lines extending outward from a right corner portion CN of the first photoelectric device C1 and a left corner portion CN of the second photoelectric device C2. The bus lines 15 of the first and second photoelectric devices C1 and C2 may be connected to each other through the connection support member 300 accommodating the right corner portion CN of the first photoelectric device C1 and the left corner portion CN of the second photoelectric device C2.

The connection support member 300 may include a conductive core 310 having accommodation slot portions 315 for receiving the corner portions CN of the first and second photoelectric devices C1 and C2, and an insulation molding 350 for insulating the conductive core 310. The connection support member 300 may have a T-shape having portions extending in opposite directions, as illustrated in FIG. 7.

The accommodation slot portions 315 may be provided as a pair to accommodate the corner portions CN of the first and second photoelectric devices C1 and C2. In this way, the first and second photoelectric devices C1 and C2 may be electrically and structurally connected by the connection support member 300 to form a module.

In the embodiment shown in FIG. 5, the pair of accommodation slot portions 315 may be formed on the same side of the connection support member 300 and open in the same direction so as to receive the first and second photoelectric devices C1 and C2 in the same direction.

The conductive core 310 electrically connects the first and second photoelectric devices C1 and C2. In detail, the conductive core 310 may include the accommodation slot portions 315 and a connection portion 318 electrically connecting the accommodation slot portions 315. The accommodation slot portions 315 may be disposed side by side in a first direction Z1 along which the conductive core 310 extends, and the connection portion 318 electrically connecting the accommodation slot portions 315 may extend in the first direction Z1.

Each of the accommodation slot portions 315 may include an upper plate 311, a lower plate 312, and a lateral plate 313 connecting the upper plate 311 and the lower plate 312. The accommodation slot portions 315 may have a bent plate shape. The accommodation slot portions 315 may make surface contact with the bus lines 15 of the first and second photoelectric devices C1 and C2 when the first and second photoelectric devices C1 and C2 are inserted into the accommodation slot portions 315. For example, the lateral plates 313 of the accommodation slot portions 315 may make surface contact with the bus lines 15. The connection portion 318 may have a flat plate shape and connect the accommodation slot portions 315.

The conductive core 310 may have a sufficient length for covering the corner portions CN of the first and second photoelectric devices C1 and C2 from which the bus lines 15 extend outward. The conductive core 310 may be formed of any suitable conductive material, e.g., a hard metal plate or a soft metal foil.

The insulation molding 350 may insulate the conductive core 310. In addition, the insulation molding 350 may insulate the first and second photoelectric devices C1 and C2 from each other. In detail, the insulation molding 350 may include a first portion 351 extending in the first direction Z1 parallel with the conductive core 310 for insulating, e.g., outer surfaces of, the conductive core 310, and a second portion 352 extending from the first portion 351 in a second direction Z2 parallel with the first and second photoelectric devices C1 and C2 for insulating the first and second photoelectric devices C1 and C2 from each other. For example, the first direction Z1 in which the first portion 351 extends may be perpendicular to the second direction Z2 in which the second portion 352 extends. The insulation molding 350 may have a T-shape. The first and second portions 351 and 352 may be formed in one piece.

As shown in FIG. 7, the first portion 351 of the insulation molding 350 covers the conductive core 310 except for the inner sides of the accommodation slot portions 315. Therefore, the first and second photoelectric devices C1 and C2 may be electrically connected to the conductive core 310 when being inserted into the accommodation slot portions 315. For example, the first portion 351 may include an upper plate cover portion 351a and a lower plate cover portion 351b to cover the upper and lower sides of the accommodation slot portions 315. The insulation molding 350 may be formed of an insulation resin. For example, the conductive core 310 and the insulation molding 350 may be formed in one piece by an injection molding method.

With reference to FIG. 8, assembling of the connection support member 300 and the first and second photoelectric devices C1 and C2 will now be described. The corner portions CN of the first and second photoelectric devices C1 and C2 are pointed to the connection support member 300 and are inserted into the accommodation slot portions 315 of the connection support member 300. In detail, if the corner portions CN of the first and second photoelectric devices C1 and C2 from which the bus lines 15 extend outward are inserted into the accommodation slot portions 315, the bus lines 15 may be smoothly bent (or bend) according to the shapes of the inner sides of the accommodation slot portions 315 and may be brought into electric contact with the accommodation slot portions 315.

For example, the bus lines 15 extending between the first and second substrates 11 and 12 of the first and second photoelectric device C1 and C2 may be bent (or bend) around an edge portion of the first substrate 11 and may extend on the top side of the first substrate 11. For example, in each of the accommodation slot portions 315, the bus line 15 may make contact with at least one side of the accommodation slot portion 315. For example, in each of the accommodation slot portions 315, the bus lines 15 may make electric contact with the lateral plate 313 of the accommodation slot portion 115.

An insulation coating 360 may be formed on the connection support member 300. The insulation coating 360 formed on the connection support member 300 may protect inner parts of the connection support member 300, e.g., the insulation molding 350, from harsh environments, e.g., temperature variations and moisture.

In the current embodiment, an insulation filler 50 may be filled in the accommodation slot portions 315. The insulation filler 50 may protect and insulate contacts between the accommodation slot portions 315 and the first and second photoelectric devices C1 and C2 from the external environment.

Referring to FIG. 5, the bus line 15 on the right side of the first photoelectric device C1 and the bus line 15 on the left side of the second photoelectric device C2 may have different polarities and may be electrically connected to each other through the connection support member 300. In this way, the first and second photoelectric devices C1 and C2 may be electrically connected in series. For example, the bus lines 15 on the right sides of the first and second photoelectric devices C1 and C2 may have a positive polarity, and the bus lines 15 on the left sides of the first and second photoelectric devices C1 and C2 may have a negative polarity. In this case, the bus line 15 on the right side of the second photoelectric devices C1 may be connected in series with the bus line 15 on the left side of the second photoelectric device C2 through the connection support member 300.

In the embodiment shown in FIG. 5, the photoelectric module includes two photoelectric devices. However, in other embodiments, the photoelectric module may include three or more photoelectric devices. For example, the photoelectric module may include first to three photoelectric devices. In this case, the photoelectric module may include a first connection support member electrically connecting the first and second photoelectric devices, and a second connection support member electrically connecting the second and third photoelectric devices. For example, if the first to third photoelectric devices are arranged side by side, the first connection support member may accommodate and electrically connect neighboring corner portions of the first and second photoelectric devices, and the second connection support member may accommodate and electrically connect neighboring corner portions of the second and third photoelectric devices.

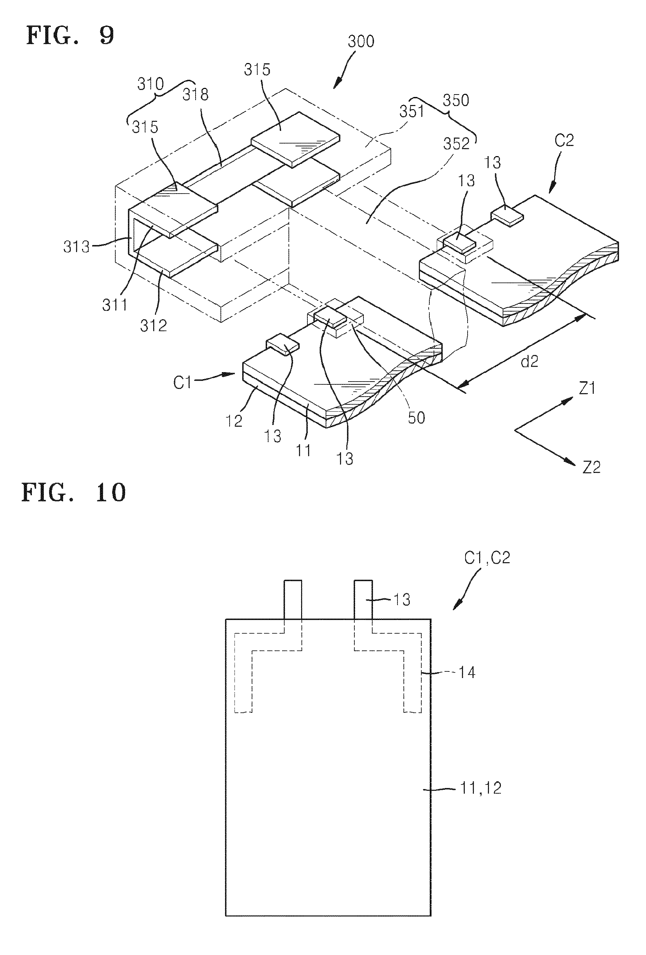

FIG. 9 illustrates a view of a modification of the photoelectric module in FIG. 5. Referring to FIG. 9, the modified photoelectric module may include at least two (first and second) photoelectric devices C1 and C2, and the connection support member 300 configured to electrically and structurally connect the first and second photoelectric devices C1 and C2 to form a module.

The connection support member 300 accommodates corner portions CN of the first and second photoelectric devices C1 and C2 that are arranged side by side, so as to electrically connect the first and second photoelectric devices C1 and C2. The first and second photoelectric devices C1 and C2 may include a pair of bus lines 13 on a right side of the first photoelectric device C1 and a left side of the second photoelectric device C2.

In the current embodiment, the bus lines 13 of the first and second photoelectric devices C1 and C2 may be relatively close to the centers of the first and second photoelectric devices C1 and C2, respectively. The first and second photoelectric devices C1 and C2 may be electrically connected to each other through the connection support member 300 accommodating the corner portions CN of the first and second photoelectric devices C1 and C2. Contacts between the connection support member 300 and the first and second photoelectric devices C1 and C2 (the bus lines 13) may be more distant from each other as compared with the embodiment shown in FIG. 5.

In detail, referring to FIG. 9, the contacts between the connection support member 300 and the bus lines 13 of the first and second photoelectric devices C1 and C2 are spaced apart from each other by a second distance d2. Referring to FIG. 5, the contacts between the connection support member 300 and the bus lines 15 of the first and second photoelectric devices C1 and C2 are spaced apart from each other by a first distance d1. The second distance d2 may be greater than the first distance d1.

The connection support member 300 may have substantially the same structure as the structure of the connection support member 300 of FIG. 5, and thus a description thereof will not be repeated.

Fig. 10 illustrates a view of the first and second photoelectric devices C1 and C2 illustrated in FIG. 9.

Referring to FIGS. 9 and 10, the first and second photoelectric devices C1 and C2 may further include lead lines 14 formed in first and second substrates 11 and 12 to change the outwardly-extending positions of the bus lines 13. The outwardly-extending positions of the bus lines 13 may be changed to vary the positions of the contacts between the connection support member 300 and the bus lines 13. For example, the positions of the contacts between the connection support member 300 and the bus lines 13 may be varied to protect and insulate the contacts.

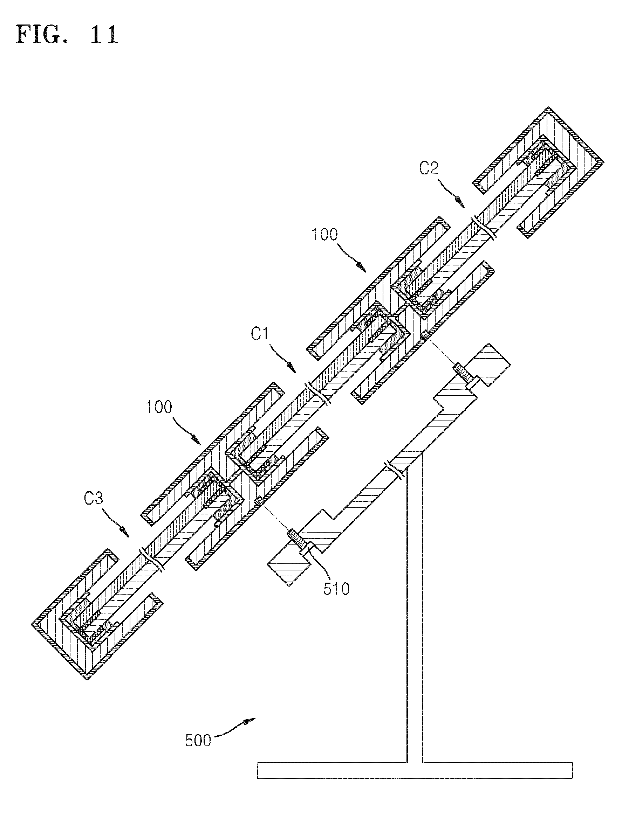

FIG. 11 illustrates a view of another aspect of the photoelectric module in FIG. 1. Referring to FIG. 11, the photoelectric module may include at least three photoelectric devices C1, C2, and C3, and a plurality of connection support members 100 configured to electrically and structurally connect the photoelectric devices C1, C2, and C3 to form a module. In addition, the photoelectric module may further include an installation frame 500 for supporting the photoelectric devices C1, C2, and C3 at an upwardly oblique angle with a bottom surface.

The photoelectric devices C1, C2, and C3 may be fixed to the installation frame 500 through the connection support members 100. For example, the connection support members 100 and the installation frame 500 may be mechanically coupled using bolts 510. In other embodiments, the connection support members 100 may be supported on the installation frame 500 without slippage owing to a threshold structure (not shown) formed on the installation frame 500. For example, the threshold structure may be a guide rail (not shown) structure.

The connection support members 100 may connect the photoelectric devices C1, C2, and C3 electrically and structurally to form a module, and the photoelectric devices C1, C2, and C3 may be coupled to the installation frame 500 through the connection support members 100. For example, one of the connection support members 100 may connect the first and second photoelectric devices C1 and C2 electrically and structurally, and the other of the connection support members 100 may connect the second and third electrically and structurally.

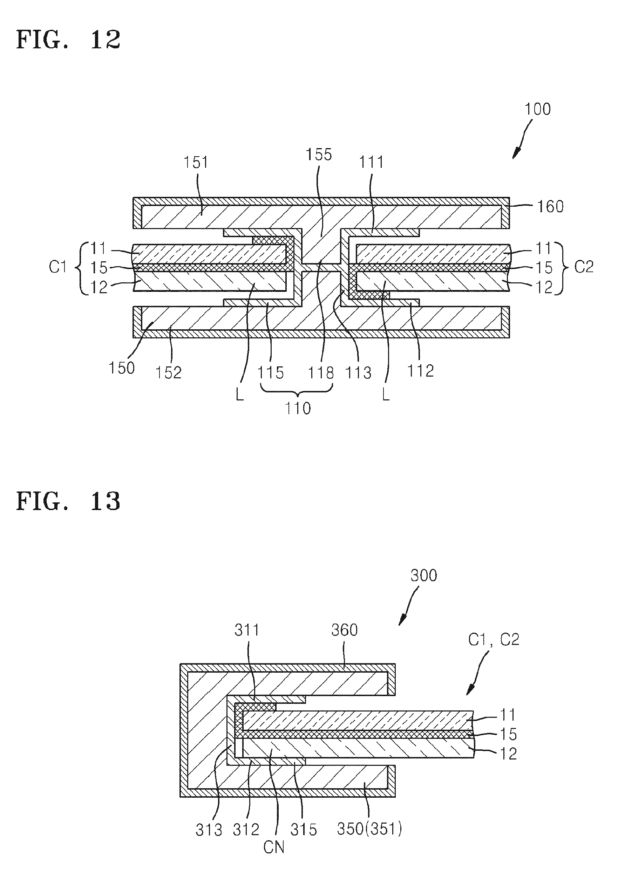

FIG. 12 illustrates a view of a modification of the photoelectric module illustrated in FIG. 3. Referring to FIG. 12, the modified photoelectric module may include the at least two (first and second) photoelectric devices C1 and C2, and the connection support member 100 configured to electrically and structurally connect the first and second photoelectric devices C1 and C2. The connection support member 100 may accommodate sides L of the first and second photoelectric devices C1 and C2 from which bus lines 15 extend outward. The connection support member 100 may accommodate the sides L of the first and second photoelectric devices C1 and C2, and the (first) bus line 15 extending from the first photoelectric device C1 may be electrically connected to the (second) bus line 15 extending from the second photoelectric device C2 through the connection support member 100.

The connection support member 100 may include the conductive core 110 having accommodation slot portions 115 for receiving portions of the first and second photoelectric devices C1 and C2, and the insulation molding 150 for insulating the conductive core 110.

In one of the accommodation slot portions 115, the first bus line 15 may extend from a region between first and second substrates 111 and 12 of the first photoelectric device C1 and may be bent (or bend) around an edge portion of the first substrate 11. Then the first bus line 15 may extend on the top side of the first substrate 11. Similarly, in the other of the accommodation slot portions 115, the second bus line 15 may extend from a region between first and second substrates 111 and 12 of the second photoelectric device C2 and may be bent (or bend) around an edge portion of the second substrate 12. Then, the second bus line 15 may extend on the bottom side of the second substrate 12.

According to the embodiment shown in FIG. 12, in each of the accommodation slot portions 115, the bus line 15 may make contact with at least two sides (or two inner surfaces) of the accommodation slot portion 115. For example, in each of the accommodation slot portions 115, the bus line 15 may make electric contact with a lateral plate 113 and one of an upper plate 111 and a lower plate 112 of the accommodation slot portion 115.

For example, when the bus lines 15 are inserted in the accommodation slot portions 115, the bus lines 15 may be naturally bent and brought into electric contact with two sides of the accommodation slot portion 115. For example, each of the bus lines 15 may be press-fitted into the accommodation slot portion 115 and brought into contact with two sides of the accommodation slot portion 115 by pressure.

Since each of the bus lines 15 makes electric contact with at least two sides of the connection support member 100 (the accommodation slot portion 115), the electric resistance between the bus lines 15 and the connection support member 100 may be reduced, and thus the electric resistance between output terminals of the photoelectric module may be reduced to improve the output power of the photoelectric module.

FIG. 13 illustrates a view of a modification of the photoelectric module in FIG. 8. Referring to FIG. 13, the modified photoelectric module may include the at least two (first and second) photoelectric devices C1 and C2, and the connection support member 300 configured to electrically and structurally connect the photoelectric devices C1 and C2.

Each of the first and second photoelectric devices C1 and C2 may include the first and second substrates 11 and 12 coupled to face each other, and the bus line 15 extending from the region between the first and second substrates 11 and 12. The (first and second) bus lines 15 of the first and second photoelectric devices C1 and C2 may be electrically connected to each other through the connection support member 300. By this, the first and second photoelectric devices C1 and C2 may be electrically connected in series or parallel. For example, the first and second bus lines 15 may include a pair of bus lines extending from a right corner portion CN of the first photoelectric device C1 and a left corner portion CN of the second photoelectric device C2. The first and second bus lines 15 of the first and second photoelectric devices C1 and C2 may be connected to each other through the connection support member 300 accommodating the right corner portion CN of the first photoelectric device C1 and the left corner portion CN of the second photoelectric device C2.

The connection support member 300 may include the conductive core 310 having the accommodation slot portions 315 for receiving the corner portions CN of the first and second photoelectric devices C1 and C2, and the insulation molding 350 for insulating the conductive core 310.

The accommodation slot portions 315 may be provided as a pair to accommodate the corner portions CN of the first and second photoelectric devices C1 and C2. In this way, the first and second photoelectric devices C1 and C2 may be electrically and structurally connected by the connection support member 300 to form a module.

In the embodiment shown in FIG. 13, the first and second bus lines 15 may extending outward from regions between the first and second substrates 11 and 12 of the first and second photoelectric device C1 and C2 and may be bent (or bend) around edge portions of the first substrates 11. Then, the first and second bus lines 15 may extend on the top sides of the first substrates 11. Each of the first and second bus lines 15 may make contact with at least two sides of each of the accommodation slot portions 315 of the connection support member 300, e.g., the lateral plate 313 and one of the upper plate 311 and the lower plate 312 of the accommodation slot portion 115.

For example, when the first and second bus lines 15 are inserted in the accommodation slot portions 315, respectively, each of the first and second bus lines 15 may be naturally bent and brought into electric contact with two sides of the accommodation slot portion 315. For example, each of the first and second bus lines 15 may be press-fitted into the accommodation slot portion 315 and brought into contact with two sides of the accommodation slot portion 115 by pressure.

Since each of the first and second bus lines 15 makes electric contact with at least two sides of the connection support member 300 (the accommodation slot portion 315), the electric resistance between the first and second bus lines 15 and the connection support member 300 may be reduced, and thus the electric resistance between output terminals of the photoelectric module may be reduced to improve the output power of the photoelectric module.

The first and second bus lines 15 may be fixed to the first and second photoelectric devices C1 and C2 using an adhesive material such as adhesive tape (not shown), a welding method, or an ultrasonic soldering method. For example, the first and second photoelectric devices C1 and C2 may include electrode layers (not shown), and the first and second bus lines 15 may be fixed to the electrode layers using adhesive tape, welding, or soldering. In this case, the electrode layers and the first and second bus lines 15 may make conductive contact with each other using a conductive adhesive tape.

As described above, according to the one or more of the above embodiments, the photoelectric devices of the photoelectric module are electrically connected to each other through a simple structure. That is, the photoelectric devices are electrically connected to each other through the connection support member accommodating portions of the photoelectric devices. Therefore, complicated processes, e.g., boring holes in photoelectric device substrates or installing junction boxes on the rear sides of photoelectric devices, for connecting photoelectric devices may be eliminated. That is, the photoelectric devices may be simply connected to each other by inserting the photoelectric devices into the accommodation slot portions of the connection support member. In addition, since the photoelectric devices are structurally coupled to each other by the connection support member, an additional support structure may not be used. Further, the photoelectric devices may be coupled to an installation frame through the connection support member to support the photoelectric devices at an upwardly oblique angle with a bottom surface.

In contrast, conventional photoelectric devices may be connected to each other by boring holes through substrates of the photoelectric devices to draw electric lines through the holes to junction boxes disposed on the rear sides of the substrates and connecting lead lines extending from the junction boxes. However, such a connection method is complex because holes are bored in substrates of photoelectric devices and junction boxes are disposed on the rear sides of the photoelectric devices

It should be understood that the exemplary embodiments described therein should be considered in a descriptive sense only and not for purposes of limitation. Descriptions of features or aspects within each embodiment should typically be considered as available for other similar features or aspects in other embodiments.

As discussed, embodiments of the invention provide a photoelectric module, comprising: first and second photoelectric devices; and a connection support member electrically and structurally connecting the first and second photoelectric devices, the connection support member including: a conductive core including accommodation slot portions configured to respectively accommodate portions of the first and second photoelectric devices, the accommodation slot portions electrically contacting bus lines extending out of the first and second photoelectric devices.

In some emdodiments, the conductive core including the accommodation slot portions for the first and second photoelectric devices is integrally formed.

In some embodiments, each accommodation slot portion is configured to accommodate a respective portion of the first and second photoelectric devices from which the bus lines extend outward.

In some embodiments, the conductive core includes a pair of accommodation slot portions, the pair of accommodation slot portions being configured to accommodate the first and second photoelectric devices, respectively

In some embodiments, the conductive core further comprises a connection portion electrically connecting the pair of accommodation slot portions.

In some embodiments, the accommodation slot portions for the first and second photoelectric devices open in opposite directions. In some embodiments, the pair of accommodation slot portions is configured to accommodate mutually-facing sides of the first and second photoelectric devices, respectively.

In some embodiments, wherein the accommodation slot portions of the first and second photoelectric devices open in a same direction. In some embodiments, the pair of accommodation slot portions is configured to accommodate neighboring corner portions of the first and second photoelectric devices, respectively.

In some embodiments, the insulation molding includes: a first portion extending in a first direction parallel with the conductive core to insulate the conductive core; and a second portion extending from the first portion in a second direction parallel with the first and second photoelectric devices for insulating the first and second photoelectric devices from each other. In some embodiments, the first and second portions of the insulation molding are integral with each other, the insulation molding having a T-shape.

In some embodiments, the accommodation slot portion has a bent shape and includes: an upper plate; a lower plate; and a lateral plate connecting the upper and lower plates. In some embodiments, the bus lines contacting the lateral plate of the accommodation slot portion.

In some embodiments, each of the bus lines extending outward from the first and second photoelectric devices electrically contacts the lateral and upper plates, or the lateral and lower plates of the accommodation slot portion.

In some embodiments, the insulation molding includes: an upper plate cover portion covering the upper plates of the pair of accommodation slot portions; a lower plate cover portion covering the lower plates of the pair of accommodation slot portions; and a block portion between the upper plate cover portion and the lower plate cover portion to arranged surround a connection portion between the pair of accommodation slot portions.

In some embodiments, each of the first and second photoelectric devices includes first and second substrates coupled to face each other, and each of the bus line extends outward from a region between the first and second substrates.

In some embodiments, each of the bus lines extending outward from the region between the first and second substrates bends around an edge portion of the first substrate to extend on a top side of the first substrate, or bends around an edge portion of the second substrate to extend on a bottom side of the second substrate.

In some embodiments, the photoelectric module further comprises an insulation molding configured to insulate the conductive core. In some embodiments, the insulation molding is on an outer surface of the accommodation slot portion, an insulation coating being positioned on an outer surface of the insulation molding to protect the insulation molding.

In some embodiments, the photoelectric module further comprises an insulation filler in the accommodation slot portions. In some embodiments, the insulation filler seals contacts between the accommodation slot portions and the bus lines.

In some embodiments, the photoelectric module further comprises an installation frame configured to support the first and second photoelectric devices above a bottom surface, the first and second photoelectric devices being coupled to the installation frame through the connection support member. In some embodiments, the connection support member is coupled to the installation frame.

In some embodiments, each of the bus lines extending outward from the first and second photoelectric devices is arranged to contact at least two sides of the connection support member.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A photoelectric module, comprising:
first and second photoelectric devices; and
a connection support member electrically and structurally connecting the first and second photoelectric devices, the connection support member including:
a conductive core including accommodation slot portions configured to respectively accommodate portions of the first and second photoelectric devices, the accommodation slot portions electrically contacting bus lines extending out of the first and second photoelectric devices.

2. The photoelectric module as claimed in claim 1, wherein each accommodation slot portion is configured to accommodate a respective portion of the first and second photoelectric devices from which the bus lines extend outward.

3. The photoelectric module as claimed in claim 1 or 2, wherein the conductive core further comprises a connection portion electrically connecting the accommodation slot portions for the first and second photoelectric devices.

4. The photoelectric module as claimed in any one of claims 1 to 3, wherein the accommodation slot portions for the first and second photoelectric devices open in opposite directions;
optionally wherein the accommodation slot portions for the first and second photoelectric devices are configured to accommodate mutually-facing sides of the first and second photoelectric devices, respectively.

5. The photoelectric module as claimed in any one of claims 1 to 3, wherein the accommodation slot portions of the first and second photoelectric devices open in a same direction;
optionally wherein the accommodation slot portions for the first and second photoelectric devices are configured to accommodate neighboring corner portions of the first and second photoelectric devices, respectively.

6. The photoelectric module as claimed in claim 5, wherein the insulation molding includes:
a first portion extending in a first direction parallel with the conductive core to insulate the conductive core; and
a second portion extending from the first portion in a second direction parallel with the first and second photoelectric devices for insulating the first and second photoelectric devices from each other;
optionally wherein the first and second portions of the insulation molding are integral with each other, the insulation molding having a T-shape.

7. The photoelectric module as claimed in any one of claims 1 to 6, wherein each accommodation slot portion has a bent shape and includes:
an upper plate;
a lower plate; and
a lateral plate connecting the upper and lower plates;
optionally wherein the bus lines are arranged to contact the lateral plate of the accommodation slot portion.

8. The photoelectric module as claimed in claim 7, wherein each of the bus lines extending outward from the first and second photoelectric devices electrically contacts the lateral and upper plates, or the lateral and lower plates of a respective accommodation slot portion.

9. The photoelectric module as claimed in claim 7 or 8, wherein the insulation molding includes:
an upper plate cover portion covering the upper plates of the accommodation slot portions for the first and second photoelectric devices;
a lower plate cover portion covering the lower plates of the accommodation slot portions for the first and second photoelectric devices; and
a block portion between the upper plate cover portion and the lower plate cover portion to arranged surround a connection portion between the accommodation slot portions for the first and second photoelectric devices.

10. The photoelectric module as claimed in any one of claims 1 to 9, wherein each of the first and second photoelectric devices includes first and second substrates coupled to face each other, and each of the bus line extends outward from a region between the first and second substrates.

11. The photoelectric module as claimed in claim 10, wherein each of the bus lines extending outward from the region between the first and second substrates bends around an edge portion of the first substrate to extend on a top side of the first substrate, or bends around an edge portion of the second substrate to extend on a bottom side of the second substrate.

12. The photoelectric module as claimed in any one of claims 1 to 11, further comprising an insulation molding configured to insulate the conductive core;
optionally wherein the insulation molding is on an outer surface of the accommodation slot portion, an insulation coating being positioned on an outer surface of the insulation molding to protect the insulation molding.

13. The photoelectric module as claimed in any one of claims 1 to 12, further comprising an insulation filler in the accommodation slot portions;
optionally wherein the insulation filler seals contacts between the accommodation slot portions and the bus lines.

14. The photoelectric module as claimed in any one of claims 1 to 13, further comprising an installation frame configured to support the first and second photoelectric devices above a bottom surface, the first and second photoelectric devices being coupled to the installation frame through the connection support member;
optionally wherein the connection support member is coupled to the installation frame.

15. The photoelectric module as claimed in any one of claims 1 to 14, wherein each of the bus lines extending outward from the first and second photoelectric devices is arranged to contact at least two sides of the connection support member.
